# EUROPÄISCHE PATENTSCHRIFT

(11) **EP 4 258 160 B1**
(45) Veröffentlichungstag und Bekanntmachung des Hinweises auf die Patenterteilung: **08.05.2024**
(21) Anmeldenummer: 22166611.8
(22) Anmeldetag: 05.04.2022
(51) Int. Cl.: G06K 7/14

(54) **LESEN VON OPTISCHEN CODES**
READING OF OPTICAL CODES
LECTURE DE CODES OPTIQUES

(43) Veröffentlichungstag der Anmeldung: 11.10.2023
(73) Patentinhaber: SICK AG, 79183 Waldkirch (DE)
(72) Erfinder: Schüler, Pascal, 79331 Teningen (DE); Zopf, Steffen, Waldkirch (DE)

(56) Entgegenhaltungen:
- Universal Postal Union: "Data definition and encoding standards", , 31. Dezember 2018 (2018-12-31), XP055946697, Gefunden im Internet: URL:https://www.upu.int/UPU/media/upu/file s/postalSolutions/programmesAndServices/st andards/S10-12.pdf [gefunden am 2022-07-27]

## Beschreibung

Die Erfindung betrifft ein Verfahren zum Lesen eines optischen Codes sowie einen optoelektronischen Codeleser nach dem Oberbegriff von Anspruch 1 beziehungsweise 14.

Codeleser sind von Supermarktkassen, zur automatischen Paketidentifikation, Sortierung von Postsendungen, von der Gepäckabfertigung in Flughäfen und aus anderen Logistikanwendungen bekannt. In einem Codescanner wird ein Lesestrahl mittels eines Drehspiegels oder eines Polygonspiegelrads quer über den Code geführt. Ein kamerabasierter Codeleser nimmt mittels eines Bildsensors Bilder der Objekte mit den darauf befindlichen Codes auf, und eine Bildauswertungssoftware extrahiert aus diesen Bildern die Codeinformation.

In einer wichtigen Anwendungsgruppe werden die codetragenden Objekte an dem Codeleser vorbei gefördert. Ein scannender Codeleser erfasst dabei die jeweils nacheinander in seinen Lesebereich geführten Codes. Alternativ liest in einem kamerabasierten Codeleser eine Zeilenkamera die Objektbilder mit den Codeinformationen sukzessive und zeilenweise mit der Relativbewegung ein. Mit einem zweidimensionalen Bildsensor werden regelmäßig Bilddaten aufgenommen, die sich je nach Aufnahmefrequenz und Fördergeschwindigkeit mehr oder weniger überlappen. Damit die Objekte in beliebiger Orientierung auf dem Förderer angeordnet werden können, sind oft mehrere Codeleser an einem Lesetunnel vorgesehen, um Objekte von mehreren oder allen Seiten aufzunehmen. Auch ein scannender Codeleser erfasst die Remission und damit letztlich Bildzeilen, die zu einem Objektbild zusammengefügt werden können, auch wenn hierfür in der Praxis ein Bildsensor vorgezogen wird. In einem solchen Objektbild können Codebereiche identifiziert und ein- oder zweidimensionale Codes ausgelesen werden.

Für einen Codeleser oder einen Lesetunnel stellt eine hohe Leserate eines der wichtigsten Qualitätskriterien dar. Lesefehler zwingen zu aufwändigen Fehlerbehebungen, wie dem erneuten manuellen Abscannen oder einer Nachsortierung. Die Ursache für solche Fehler kann in der Qualität des Codes selbst liegen, in einer ungünstigen Lesesituation beispielsweise mit einem Code unter einer Folie, die Reflektionen verursacht, und schließlich auch in Auswertungsfehlern etwa im Zuge einer Binarisierung von Grauwerten oder in Form von ungenau berechneten Abtastpositionen.

Um Lesefehler zu vermeiden, sind herkömmliche Decoder für zweidimensionale Codes wie DataMatrix, QR, Aztec, Maxicode, Dot-Code oder auch Stapelcodes wie PDF417 und MicroPDF mit einer Reed-Solomon-Korrektur ausgestattet. Das ermöglicht ein starkes Korrekturverfahren, mit dem selbst Codes mit großflächigeren Defekten noch richtig gelesen werden. Das ermöglicht nicht nur, ansonsten nicht lesbare Codes (NoRead) doch noch zu lesen, sondern vermeidet auch sogenannte Fehllesungen (MisRead). Dabei wird ein Code falsch gelesen und dies nicht erkannt. Bei einer Reed-Solomon-Korrektur kommt das praktisch nicht vor. Wird deren Fehlerkapazität überschritten, kann der entsprechende Code einfach nicht mehr decodiert werden (NoRead).

Für Barcodes jedoch steht die Reed-Solomon-Korrektur nicht zur Verfügung. Dabei soll der Begriff Barcode als 1D-Strichcode verstanden werden, in der Literatur werden abweichend auch 2D-Codes bisweilen als Barcodes bezeichnet. Das Lesen eines Barcodes wird üblicherweise mittels einer Prüfsumme oder Checksumme verifiziert. Wenn die aus den gelesenen Nutzdaten errechnete Prüfsumme und die mitgelesene Prüfsumme übereinstimmen, wird von einer korrekten Decodierung ausgegangen. Eine Abweichung bedeutet, dass mindestens ein Zeichen in den Nutzdaten oder der Prüfsumme falsch gelesen wurde, und dies führt in der Regel zu einem Lesefehler (NoRead).

Es ist möglich, über die Prüfsumme ein einzelnes nicht decodierbares oder defektes Nutzzeichen zu korrigieren, d.h. in einer Art Invertierung des Prüfsummenverfahrens das betroffene Nutzzeichen im Nachhinein auf einen Wert zu setzen, mit dem dann die aus den Nutzdaten errechnete Prüfsumme mit der gelesenen Prüfsumme übereinstimmt. Diese Form der Korrektur ist auf ein Einzelzeichen beschränkt und für großflächiger beeinträchtigte Codes nicht anwendbar. Es bleibt dann bei einem Lesefehler (NoRead).

Außerdem kann es vorkommen, dass auch die Prüfsumme unbemerkt falsch ausgelesen wurde. Das hat zur Konsequenz, dass das nicht decodierbare oder defekte Nutzzeichen durch den Korrekturversuch auf einen falschen Wert gesetzt wird. Es ist sogar möglich, dass die Nutzzeichen sämtlich völlig korrekt waren und überhaupt erst der Korrekturversuch mit der falschen Prüfsumme einen Fehler einführt. Vergleichbares kann selbst bei korrekter Prüfsumme geschehen, wenn unbemerkt mehr als ein Nutzzeichen falsch decodiert worden ist und die kumulierten Fehler zufällig in die richtige Prüfsumme münden. Das einfache Korrekturverfahren aus der Prüfsumme für Barcodes erhöht somit mit der Leserate zugleich das Risiko von Fehllesungen (MisRead).

Eine Prüfsumme fängt folglich nur Einzelfehler verlässlich ab, und die herkömmliche Korrektur für Barcodes ist deshalb anfällig in Situationen mit Mehrfachfehlern. In der Praxis ist es aber gar nicht ungewöhnlich, dass ein Code an mehreren Stellen beeinträchtigt ist. Beispiele sind stark gewellte Untergründe bei flexiblen Verpackungen wie Tüten, teilweise in eine Kartonage-Falz geklebte Barcodeetiketten oder Barcodes unter Folie mit starken Reflektionen mit vielen lokalen, flächigen Defekten.

In der EP 3 428 835 B1 wird ein Verfahren zum Lesen eines optischen Codes vorgestellt, bei dem in einer Vorkorrektur, die einem Prüfverfahren vorgelagert ist, an mindestens einer Position des Codes ein Codewort durch ein für diese Position bekanntes Codewort ersetzt wird. Die bekannten Codewörter sind parametriert, von einer Datenbank eines übergeordneten Systems vorgegeben oder aus einer Historie von gelesenen Codes eingelernt. Das ist eine Vorkorrektur, die dafür gedacht ist, eine nachfolgende Reed-Solomon-Korrektur zu ergänzen. Diese Vorkorrektur leistet keine Verbesserung für diejenigen variablen Abschnitte des Codes, für die keine Codewörter bekannt sind. Für Fehlerkorrekturen in den variablen Abschnitten ist die nachgelagerte Reed-Solomon-Korrektur zuständig, der Vorteil der EP 3 428 835 B1 besteht darin, dass dafür nach der Vorkorrektur die volle Fehlerkapazität zur Verfügung steht und sich nicht schon teilweise für Korrekturen der bekannten Codewörter verbraucht. Bei einem Barcode ohne die Möglichkeit der Reed-Solomon-Korrektur bleiben folglich zumindest bezüglich eines variablen Anteils des Codes alle beschriebenen Nachteile der nur sehr begrenzt möglichen Korrektur über die Prüfsumme bestehen.

UPU S10 ist ein Barcode-Standard, der beispielsweise in dem Dokument Universal Postal Union: "Data definition and encoding standards", 31. Dezember 2018, XP055946697 beschrieben ist, das unter https://www.upu.int/UPU/media/upu/files/postalSolutions/programmesAndServices/standards/S10-12.pdf abgerufen werden kann. Ein UPU S10 Barcode weist 13 Zeichen neben Startzeichen, Stopzeichen und einem Symbology Check Value auf, nämlich in dieser Reihenfolge zwei alphabetische Zeichen für einen Service Indicator Code, eine achtstellige Seriennummer, ein numerisches Prüfzeichen und zwei alphabetische Zeichen für einen Ländercode.

Daher ist Aufgabe der Erfindung, ein noch verlässlicheres und robusteres Verfahren zum Lesen von optischen Codes anzugeben.

Diese Aufgabe wird durch ein Verfahren zum Lesen eines optischen Codes sowie einen optoelektronischen Codeleser nach Anspruch 1 beziehungsweise 14 gelöst. Vorsorglich sei klargestellt, dass es sich um ein automatisch ablaufendes, computerimplementiertes Verfahren handelt. Ein menschlicher Betrachter wäre mit der Informationsfülle ohnehin heillos überfordert. Der optische Code enthält eine Botschaft, das ist derjenige Klartext, der durch den optischen Code vermittelt werden soll und darin codiert ist. Die Botschaft weist eine Zeichenkette mit einer Vielzahl von Zeichen auf. Sie enthält vorzugsweise neben den Nutzzeichen auch mindestens ein Prüfzeichen, beispielsweise eine Prüfsumme (Checksumme). Um den Code und damit die Botschaft zu lesen, werden zunächst auf einem der bekannten und einleitend beschriebenen Wege Bilddaten mit dem optischen Code aufgenommen. In den Bilddaten werden dann vorzugsweise durch eine Vorverarbeitung Codebereiche aufgefunden, welche die Bilddaten beispielsweise anhand des Kontrasts segmentiert, und der jeweilige Code in den Codebereichen wird decodiert und dadurch die Botschaft gelesen.

Die gelesenen Zeichen der Botschaft werden mit einem Schema verglichen. Das Schema enthält Vorwissen über die zu lesenden Codes. Dazu gehört ein Fixanteil: An mindestens einer Position der Botschaft wird laut dem Schema ein bestimmtes fixes Zeichen erwartet, es ist folglich bekannt, welches Zeichen dort stehen beziehungsweise wie die Botschaft an dieser Position lauten müsste. Es kann mehrere Schemata geben, wenn in einer Anwendungssituation Codefamilien mit jeweiligen eigenen Fixanteilen vorkommen, in diesem Fall wird vorzugsweise zunächst das geeignete Schema beispielsweise mit der besten Übereinstimmung zu dem aktuellen Code identifiziert und dann verwendet. Das Schema ermöglicht es, falsch gelesene Botschaften zu erkennen, wenn der Fixanteil des Schemas nicht wie erwartet in der Botschaft gelesen wurde, und/oder die gelesene Botschaft zu korrigieren, indem aus dem Vorwissen des Fixanteils des Schemas Teile der Botschaft korrigiert oder ersetzt werden. Bis hierhin ist das erfindungsgemäße Vorgehen ähnlich der einleitend genannten EP 3 428 835 B1, auf die ergänzend verwiesen wird.

Die Erfindung geht nun von dem Grundgedanken aus, in dem Schema zusätzlich einen variablen Anteil vorzusehen. Für mindestens eine Position der Botschaft wird ein variables Zeichen erwartet, das nicht auf ein fixes Zeichen festgelegt ist, jedoch nur in einem Teilbereich der insgesamt möglichen Zeichen variiert. Typische Beispiele für ein variables Zeichen sind Ziffern oder Buchstaben. Der Vergleich der gelesenen Zeichen der Botschaft mit dem Schema schließt den variablen Anteil ein. Wird an einer Position eines variablen Zeichens ein Zeichen der Botschaft gelesen, das nicht dem Schema entspricht, so wird dies als Fehler erkannt. Beispielsweise wird an einer Position, an der laut Schema ein Buchstabe stehen müsste, eine Ziffer gelesen. Dieser Fehler kann als solcher ausgegeben werden (MisRead), oder es können Korrekturversuche beispielsweise aus einer Prüfsumme unternommen werden. Gemäß ihrer Definition schließen fixe Zeichen und variable Zeichen einander aus, folglich sind ihre jeweiligen Positionen gemäß dem Schema verschieden.

Die Erfindung hat den Vorteil, dass die Leserate weiter erhöht wird, und dies sowohl in Bezug auf Nichtlesungen (NoRead) als auch Fehllesungen (MisRead). Eine Nichtlesung erfordert eine mühsame Nachbehandlung beispielsweise durch erneutes manuelles Erfassen des Codes, während eine Fehllesung sogar unerkannte und besonders teure Fehler beim Sortieren, Verschicken und bei sonstigen durch die Codes gesteuerten Zuweisungen bedeuten kann. Die erfindungsgemäße Korrektur ist nicht auf Einzelfehler begrenzt. Es können dabei auch fehlende Zeichen ergänzt werden, und dabei kann die Codelänge wieder korrekt rekonstruiert werden. Das Risiko unerkannter Fehllesungen insbesondere nach einer fehlgeschlagenen Korrektur ist erheblich reduziert. Wie noch genauer erläutert, lassen sich Schemata benutzerfreundlich über eine effiziente Syntax beispielsweise in einer Benutzeroberfläche parametrieren und sogar automatisch aus dem Decodierprozess oder entsprechenden Logfiles einlernen. Die Erfindung ist besonders geeignet für Barcodes, bei denen die Vorkorrektur der EP 3 428 835 B1 nicht ausreicht, weil keine anschließende Reed-Solomon-Korrektur zur Verfügung steht. Dennoch bleibt es möglich, die Erfindung bei 2D-Codes anstelle oder in Ergänzung zu einer Reed-Solomon-Korrektur einzusetzen, die zwar für sich robust und mächtig, deren Fehlerkapazität aber nicht unbegrenzt ist.

Das Schema weist bevorzugt eine Codelänge auf und/oder enthält für jede Position ein fixes Zeichen oder ein variables Zeichen. Zu dem Schema gehört somit die Information der Codelänge, der Gesamtzahl an Zeichen der Botschaft. Das Schema ist vorzugsweise vollständig, für jede Position der Botschaft ist also aus dem Schema bekannt, welches fixe Zeichen dort steht beziehungsweise welcher Teilbereich möglicher Zeichen dort als variables Zeichen möglich ist. In dieser Vollständigkeit steckt implizit die Codelänge, die aber dennoch zusätzlich ein expliziter Parameter des Schemas sein kann. Ein Schema kann auch unvollständig sein, es gibt dann mindestens ein völlig freies Zeichen in den Grenzen der grundsätzlichen Codespezifikation. Das kann insbesondere ein vorübergehender Zustand während eines Einlernens eines Schemas sein.

Als das anzuwendende Schema unter mehreren Schemata wird bevorzugt dasjenige ausgewählt, dessen fixe Zeichen sich am besten in der gelesenen Botschaft wiederfinden. Es kann einen Pool von Schemata für unterschiedliche Codefamilien geben, die in einer Anwendungssituation erwartet werden. Dann ist eine Wahl zu treffen, mit welchem Schema auf falsch gelesene Botschaften geprüft beziehungsweise die gelesene Botschaft korrigiert wird. Dazu lässt sich der Fixanteil des Schemas als eine Art Fingerabdruck verstehen. Es wird dasjenige Schema verwendet, dessen Fingerabdruck am besten zu der gelesenen Botschaft passt. Im Idealfall wird der gesamte Fixanteil eines Schemas in der Botschaft gelesen. Bei nur partieller Übereinstimmung kann eine Wertung beispielsweise über die Anzahl dem Schema entsprechender gelesener fixer Zeichen und/oder den höchsten Anteil solcher gelesener fixer Zeichen erfolgen.

Der Code weist bevorzugt eine Prüfsumme auf, und das Lesen der Botschaft wird anhand der Prüfsumme validiert. Die Botschaft umfasst dann neben den Nutzzeichen mindestens ein Prüfzeichen. Aus den gelesenen Nutzzeichen wird eine Prüfsumme berechnet, mittels eines Algorithmus, der demjenigen entspricht, mit dem die Prüfsumme ursprünglich bei der Erzeugung des Codes errechnet wurde. Stimmen berechnete und gelesene Prüfsumme überein, so gilt die Botschaft als validiert. Dadurch werden Fehllesungen (MisRead) abgefangen.

An einer Position eines variablen Zeichens wird bevorzugt ein nicht in den Teilbereich der für das variable Zeichen möglichen Zeichen fallendes oder ein nicht lesbares Zeichen mittels der Prüfsumme korrigiert und das Ergebnis nur als korrekt gelesene Botschaft akzeptiert, wenn das korrigierte Zeichen in den Teilbereich der für das variable Zeichen möglichen Zeichen fällt. Hier erfolgt im variablen Anteil eine Korrektur anhand der Prüfsumme. Einleitend wurde erläutert, dass dies nur für Einzelfehler möglich ist und im Falle von Mehrfachfehlern zusätzliche Fehllesungen (MisRead) erzeugt werden können. Die Prüfsumme kann grundsätzlich nur entweder die Integrität der Botschaft verifizieren oder zur Korrektur herangezogen werden, weil die Korrektur letztlich die Integrität mit der Prüfsumme erzwingt. Das Schema ermöglicht hier eine zusätzliche Absicherung, denn die korrigierte Botschaft muss immer noch das Schema erfüllen. Dadurch wird zumindest ein Teil der zusätzlichen Fehllesungen abgefangen.

Es werden vorzugsweise dann, wenn ein Mindestanteil der fixen Zeichen des Schemas, insbesondere mindestens die Hälfte, in der Botschaft korrekt gelesen wurde, die übrigen fixen Zeichen des Schemas in die Botschaft übernommen. Das betrifft nochmals die Korrektur mittels Fixanteil. Sie wird hier unter die zusätzliche Bedingung gestellt, dass der Fixanteil des Schemas sich mit ausreichender Verlässlichkeit in der gelesenen Botschaft findet. Dazu wird ein Mindestanteil mit dem Schema übereinstimmend gelesener fixer Zeichen verlangt, insbesondere mindestens die Hälfte. Die fixen Zeichen der Botschaft können durch Zeichen des Fixanteils überschrieben, aber auch in dem Sinne eingefügt werden, dass sich dadurch die Botschaft verlängert. Einen Hinweis darauf, dass diese Korrektur erforderlich ist, kann eine fehlgeschlagene Validierung über die Prüfsumme geben. Bei einer über die Prüfsumme validierten Botschaft kann aus Effizienzgründen die Überprüfung und mögliche Korrektur des Fixanteils entfallen. Umgekehrt wird vorzugsweise nach der Korrektur nochmals anhand der Prüfsumme validiert beziehungsweise die Codelänge überprüft. Liegt weiterhin ein Fehler vor, so wird dies als Lesefehler (NoRead) ausgegeben. Denkbar ist zuvor noch der Versuch, über die Prüfsumme im variablen Anteil zu korrigieren, mit dem hierzu bereits geschilderten Risiko einer dadurch provozierten Fehllesung (MisRead). Ein Lesefehler (NoRead) liegt vorzugsweise auch dann vor, wenn der Mindestanteil korrekt gelesener fixer Zeichen nicht erreicht ist, die Zuordnung zu dem Schema ist dann zu unsicher, um die Korrektur zu versuchen. In dieser Hinsicht kann die Robustheit über den Mindestanteil eingestellt werden.

Vorzugsweise wird eine Botschaft, deren Länge nicht mit der Codelänge des Schemas übereinstimmt oder die an einer Position eines variablen Zeichens ein Zeichen aufweist, das nicht in den Teilbereich der für das variable Zeichen möglichen Zeichen fällt, als Fehllesung eingestuft. Dieser Schritt folgt vorzugsweise auf eine Korrektur, ist aber auch unabhängig davon möglich, insbesondere wenn von Anfang an die Botschaft anhand der Prüfsumme validiert werden konnte. Die Codelänge und die Vorgaben des Schemas hinsichtlich variabler Zeichen ermöglichen, Fehllesungen im Mehrfachfehlerfall wenigstens teilweise noch aufzudecken. Aus mehreren falschen Zeichen kann sich prinzipiell auch dann die gelesene Prüfsumme ergeben, wenn die variablen Zeichen das Schema erfüllen, aber die Wahrscheinlichkeit für einen solchen Mehrfachfehler ist deutlich reduziert. Das gilt gleichsam für Fälle, in denen die Prüfsumme korrekt gelesen wurde wie solche, in denen die Prüfsumme selbst Teil des Mehrfachfehlers ist.

Ein Schema weist bevorzugt mindestens einen der folgenden Teilbereiche der möglichen Zeichen eines variablen Zeichens auf: nicht druckbare Zeichen, Sonderzeichen, Ziffern, Buchstaben, Kleinbuchstaben, Großbuchstaben. Das sind besonders geeignete Beispiele für Unterteilungen oder Klassen der in einer Botschaft denkbaren Zeichen. Im Prinzip könnte die Unterteilung ganz willkürlich erfolgen. Derartige semantische Klassen erleichtern aber dem Benutzer das Verständnis, so dass die Anwendung leichter diagnostiziert und optimiert werden kann. Zudem sind Regelmäßigkeiten in Codes in der Praxis ebenfalls eher in Form semantischer Klassen als beliebige Unterteilungen zu finden. Häufig sind die möglichen Zeichen eines Codes durch die Zahlen 0..127 des ASCII-Codes repräsentiert. Die genannten Teilbereiche können im ASCII-Code wiedergefunden werden.

Ein Schema wird bevorzug als regulärer Ausdruck formuliert, der für die jeweiligen Positionen die zulässigen Zeichen angibt. Ein regulärer Ausdruck erleichtert es dem Benutzer, das Schema zu verstehen und gegebenenfalls zu editieren. Zugleich wird die interne Verarbeitung erleichtert und die Fehleranfälligkeit beim Programmieren der Decoder verringert. Alternativ ist eine proprietäre Definition von Schemata vorstellbar, die aber vorzugsweise die Übersichtlichkeit und formale Regelmäßigkeit regulärer Ausdrücke zumindest annähernd erreicht.

Zum Einlernen eines Schemas wird vorzugsweise eine Vielzahl gelesener Botschaften ausgewertet, wobei insbesondere die gelesenen Botschaften im Betrieb erfasst oder aus einem Logfile geladen werden. Zwar wäre grundsätzlich denkbar, ein Schema unmittelbar vorzugeben, sei es durch Parametrierung in einer insbesondere grafischen Benutzerschnittstelle oder durch Einlesen mittels Datenträger oder Netzwerk. Für die Diagnose oder Verbesserung von Schemata ist das durchaus von Vorteil. In dieser Ausführungsform ist aber ein automatisches Einlernen vorgesehen, das den Benutzer von dieser Aufgabe befreit. Das Einlernen basiert auf gelesenen Botschaften, die vorzugsweise aus dem laufenden oder einem früheren Betrieb stammen können, insbesondere einem Logfile. Denkbar ist weiterhin eine Anpassung von Schemata während des Betriebs. Es ist von Vorteil, wenn bekannt ist, dass die Botschaften, aus denen das Schema eingelernt wird, korrekt gelesene Botschaften sind. Vorzugsweise werden zudem nur Leseergebnisse verwendet, die von Anfang an korrekt gelesen wurden, insbesondere keine Korrektur aus der Prüfsumme erfahren haben. Beispielsweise durch statistische Verfahren ließe sich aber aus gelesenen Botschaften selbst dann ein Schema ableiten, wenn in einigen Botschaften Zeichen fehlen und/oder einige Botschaften falsche Zeichen enthalten. Beim Einlernen findet vorzugsweise eine Sortierung der gelesenen Botschaften statt, damit nur Codes aus einer Codefamilie Eingang finden beziehungsweise mehrere Schemata für mehrere Codefamilien eingelernt werden können. Kriterien für die Sortierung können die Codelänge, aber auch Teile der Schemata selbst sein, insbesondere unterschiedliche Fixanteile. Es kann also im Laufe des Einlernens vorkommen, dass aus einem Schema aufgrund von Unterschieden im Fixanteil zwei oder mehr Schemata gebildet werden.

Ein Schema wird bevorzugt aus einer Verteilung gelesener Zeichen an den jeweiligen Positionen der gelesenen Botschaft eingelernt. Es wird demnach festgestellt, welche Zeichen an den jeweiligen Positionen der Botschaft vorkommen. Es kann zudem gezählt werden, wie oft ein Zeichen an der jeweiligen Position gelesen wurde.

Vorzugsweise wird an Positionen, an denen immer das gleiche Zeichen gelesen wird, das entsprechende fixe Zeichen eingelernt, und an Positionen, an denen verschiedene Zeichen gelesen werden, wird der davon gebildete Teilbereich als variables Zeichen eingelernt. Ein immer wieder gleich an einer Position gelesenes Zeichen wird damit dem Fixanteil des Schemas zugeschlagen. Es können dabei zusätzliche Vorgaben gemacht werden, etwa dass der Fixanteil einen Block benachbarter Zeichen bildet oder am Anfang oder Ende der Botschaft steht. Variieren an einer Position die gelesenen Zeichen, so wird der davon aufgespannte Teilbereich als variables Zeichen des Schemas angesehen. Dieser Teilbereich kann gegebenenfalls noch erweitert werden, um einen besonderen Teilbereich in Gänze abzudecken. Wurden beispielsweise an einer Position die Zeichen 1, 3, 6 gelesen, dann kann der Teilbereich je nach Ausführungsform genau aus diesen Zeichen {1, 3, 6} bestehen, aus der ganzen Spanne {1, 2, 3, 4, 5, 6} zwischen den gelesenen kleinsten und größten Zeichen 1, 6 unter Einschluss auch der nicht gelesenen Zeichen 2, 4, 5 oder aus der vollständigen Klasse der Ziffern. Wenn an einer Position praktisch beliebige, zufällige Zeichen gelesen wurden, dann kann für das Schema hier weder ein Fixanteil noch ein nützlicher variabler Anteil eingelernt werden. Es verbleibt eine Freistelle im Schema, ein variables Zeichen praktisch ohne Einschränkung, oder das Einlernen wird abgebrochen. Weiterhin kann versucht werden, eine Teilmenge der gelesenen Botschaften zu finden, in denen Ausreißer eliminiert sind, die diese Situation herbeigeführt haben. Die Ausreißer können ausgegeben werden, damit der Benutzer eine Möglichkeit hat zu prüfen, ob es berechtigt ist, diese gelesenen Botschaften in dem Schema nicht zu berücksichtigen.

Ein Schema wird bevorzugt zunächst mit leeren Bereichen je Position initialisiert, das jeweilige erste an einer Position gelesene Zeichen wird für diese Position gespeichert, und jedes an einer Position nach dem ersten Zeichen für diese Position gelesene Zeichen, das für diese Position noch unbekannt war, erweitert den Teilbereich für diese Position so, dass das gelesene Zeichen umfasst ist. Dies ist eine vorteilhafte Implementierung des Einlernens von Schemata. Dabei wird wie immer vorzugsweise sortiert, so dass die gelesenen Botschaften, aus denen das jeweilige Schema eingelernt wird, derselben Codefamilie zugehören. Initialisiert wird ein leeres Schema, das zunächst für keine Position Vorwissen kennt. Ein jeweils an einer Position gelesenes Zeichen wird zunächst als fixes Zeichen des Schemas betrachtet. Das sollte sich dann aber über die weiteren gelesenen Botschaften bestätigen. Es kann auch verlangt werden, dass ein fixes Zeichen mindestens m-mal oder m-aus-n-mal gelesen wurde. Wird an einer Position ein anderes Zeichen gelesen, so kann dies gemäß einem m-aus-n-Kriterium als Ausreißer betrachtet werden. Vorzugsweise spannen aber die bisher an dieser Position gelesenen Zeichen den Teilbereich eines variablen Zeichens auf. Mit jedem neuen gelesenen Zeichen an einer Position eines variablen Zeichens kann sich der Teilbereich erweitern. Vorzugsweise sollte der Teilbereich auf eine Klasse beschränkt bleiben, wie Ziffern oder Buchstaben, ansonsten sind ein besonders großer Teilbereich beziehungsweise eine Fehlermeldung des Einlernens denkbar, weil an dieser Position keine Regelmäßigkeit oder Systematik erkennbar ist, die sich in einem Schema sinnvoll erfassen lässt.

In bevorzugter Weiterbildung ist ein optoelektronischer Codeleser mit mindestens einem Lichtempfangselement zur Erzeugung von Bilddaten aus Empfangslicht und mit einer internen und/oder externen Steuer- und Auswertungseinheit vorgesehen, in der ein erfindungsgemäßes Verfahren zum Lesen von optischen Codes implementiert ist.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine schematische Übersichtsdarstellung eines Codelesers, der beispielhaft über einem Förderband montiert ist, auf dem Objekte mit zu lesenden optischen Codes gefördert werden;
- Fig. 2: ein Beispielbild eines optischen Codes unter einer Folie, der wegen Reflexen schwer zu lesen ist;
- Fig. 3: ein beispielhaftes Ablaufdiagramm zum Einlernen von Schemata zur Überprüfung und/oder Korrektur von aus optischen Codes gelesenen Botschaften;
- Fig. 4: eine Darstellung mehrerer gelesener Botschaften mit Illustration eines daraus eingelernten Schemas;
- Fig. 5: eine beispielhafte Aufteilung der möglichen Zeichen, hier im ASCII-Code, in Teilbereiche variabler Anteile eines Schemas; und
- Fig. 6: ein beispielhaftes Ablaufdiagramm für die Überprüfung und/oder Korrektur von aus optischen Codes gelesenen Botschaften anhand eines Schemas.

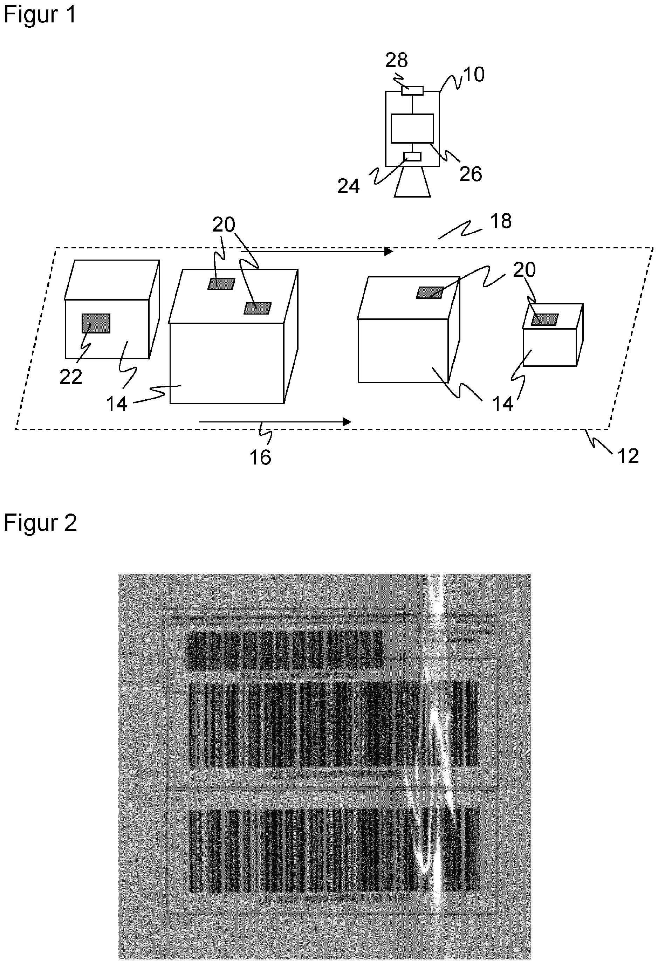

Figur 1 zeigt einen optoelektronischen Codeleser 10, der über einem Förderband 12 montiert ist, welches Objekte 14, wie durch den Pfeil 16 angedeutet, durch den Erfassungsbereich 18 des Codelesers 10 fördert. Die Objekte 14 tragen an ihren Außenflächen Codebereiche 20, die von dem Codeleser 10 erfasst und ausgewertet werden. Diese Codebereiche 20 können von dem Codeleser 10 nur dann erkannt werden, wenn sie auf der Oberseite oder zumindest von oben sichtbar angebracht sind. Daher kann abweichend von der Darstellung in Figur 1 zum Lesen eines etwa seitlich oder unten angebrachten Codes 22 eine Mehrzahl von Codelesern 10 aus verschiedenen Richtungen montiert sein, um eine sogenannte Omnilesung aus allen Richtungen zu ermöglichen. Die Anordnung der mehreren Codeleser 10 zu einem Lesesystem erfolgt in der Praxis meist als Lesetunnel. Diese stationäre Anwendung des Codelesers 10 an einem Förderband ist in der Praxis sehr häufig. Die Erfindung bezieht sich aber auf das Lesen von Codes beziehungsweise den Codeleser 10 selbst, so dass dieses Beispiel nicht einschränkend verstanden werden darf. Beispielsweise können Codes auch von Hand abgescannt, oder es kann in einer Präsentationsanwendung ein Code oder ein Objekt 14 mit einem Code in das Lesefeld des Codelesers 10 gehalten werden.

Der Codeleser 10 erfasst mit einem Lichtempfänger 24 Bilddaten der geförderten Objekte 14 und der Codebereiche 20, die von einer Steuer- und Auswertungseinheit 26 mittels Bildauswertung und Decodierverfahren weiterverarbeitet werden. Es kommt für die Erfindung nicht auf das konkrete Bildgebungsverfahren an, so dass der Codeleser 10 nach irgendeinem an sich bekannten Prinzip aufgebaut sein kann. Beispielsweise wird jeweils nur eine Zeile erfasst, sei es mittels zeilenförmigem Bildsensor oder einem Scanverfahren, und die Steuer- und Auswertungseinheit fügt die im Laufe der Förderbewegung erfassten Zeilen zu den Bilddaten zusammen. Mit einem matrixförmigen Bildsensor lässt sich schon in einer Aufnahme ein größerer Bereich erfassen, wobei auch hier das Zusammenfügen von Aufnahmen sowohl in Förderrichtung als auch quer dazu möglich ist. Die zentrale Funktion des Codelesers 10 ist das Decodieren, d.h. das Lesen der in einem optischen Code codierten Botschaft als Klartext. Die Botschaft ist eine Zeichenkette aus Nutzzeichen vorzugsweise mit mindestens einem Prüfzeichen, das typischerweise am Ende steht. Über eine Schnittstelle 28 gibt der Codeleser 10 Informationen aus, wie aus den Codes gelesene Botschaften oder Bilddaten.

Nachstehend wird unter Bezugnahme auf die Figuren 2 bis 6 eine Überprüfung und/oder Korrektur der jeweils aus einem Code gelesenen Botschaft erläutert. Vorzugsweise erfolgt dies in der Steuer- und Auswertungseinheit 26. Ebenso ist aber denkbar, Bilddaten oder Zwischenergebnisse über die Schnittstelle 28 auszugeben und zumindest einen Teil der Decodierung, Überprüfung und/oder Korrektur in ein übergeordnetes System auszulagern, wie einen Steuerungsrechner, ein Netzwerk oder eine Cloud. Vorverarbeitungen der Bilddaten zur Segmentierung und zum Auffinden von Codebereichen 20 sowie die Decodierung an sich werden als bekannt vorausgesetzt und nicht beschrieben.

Figur 2 zeigt ein Beispielbild eines optischen Codes unter einer Folie, der wegen Reflektionen schwer zu lesen ist. Auf dem Etikett befinden sich wie auch häufig in der Praxis mehrere Codes. Für das Codelesen besonders wichtig sind sogenannte sortierrelevante Codes, die die für die nachgelagerte Sortierung eines Objektes relevanten Informationen tragen. Daneben können andere Codes aufgebracht sein. Es hilft aber nichts, wenn beispielsweise der oberste Code in Figur 2 gelesen werden kann und ein sortierrelevanter Code nicht. Außerdem sind natürlich auch Situationen vorstellbar, in denen die Reflektionen oder sonstigen Beschädigungen oder Störungen des Codes sämtliche Codes eines Codebereichs 20 betreffen, oder in denen umgekehrt sämtliche Codes sortierrelevant oder deren korrektes Decodieren anderweitig für die Anwendung unverzichtbar ist.

Um die Leserate für Codes wie diejenigen in Figur 2 zu verbessern, die durch Reflektionen oder sonstige Beschädigungen beeinträchtigt sind, wird ein Vorwissen über die Codes in einem Schema erfasst. Anhand des Schemas können dann gelesene Botschaften ergänzt werden, um Lesefehler (NoReads) doch noch zu vermeiden, beziehungsweise es können damit Fehllesungen (MisReads) detektiert werden. Dies wird am Beispiel von Barcodes erläutert, wie sie auch in Figur 2 dargestellt sind. Dafür ist die Erfindung besonders nützlich, denn für andere Codetypen stehen mächtige Korrekturen wie Reed-Solomon-Codierungen zur Verfügung, ohne damit die Anwendung der Erfindung auf andere Codearten ausschließen zu wollen.

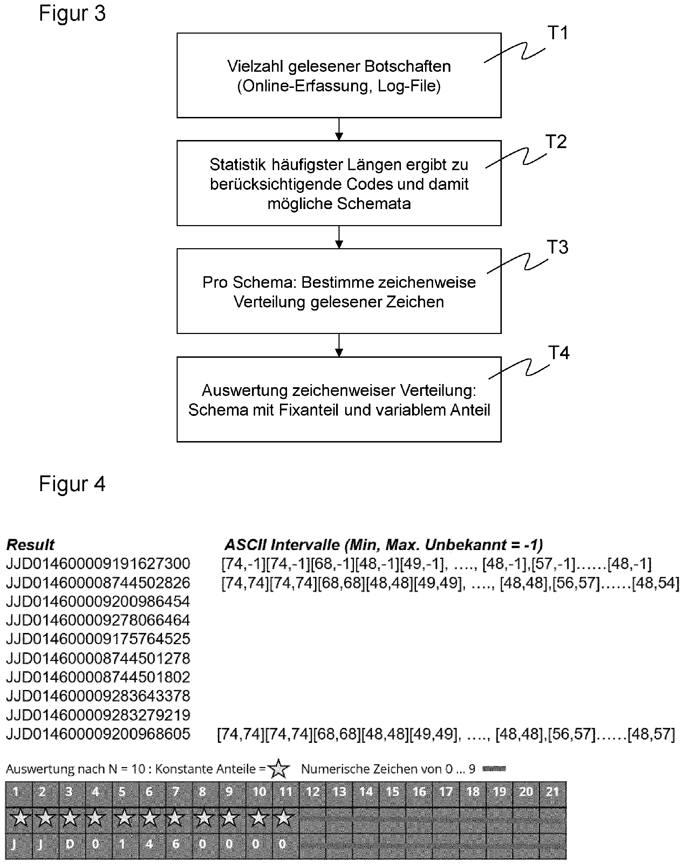

Figur 3 zeigt ein beispielhaftes Ablaufdiagramm zum automatischen Einlernen von Schemata. Alternativ kann ein Schema über eine insbesondere grafische Benutzerschnittstelle eingegeben oder von einem Datenträger eingelesen werden. Eine Benutzerschnittstelle ist auch geeignet, eingelernte Schemata anzuzeigen, zu prüfen und gegebenenfalls zu editieren.

In einem Schritt T1 wird eine Vielzahl gelesener Botschaften erfasst. Das sind Ergebnisse von Decodierungen optischer Codes, wie sie in der späteren Anwendung auftreten werden. Die gelesenen Botschaften können nach und nach während des laufenden Betriebs und/oder aus der Vergangenheit erfasst werden, beispielsweise einem Log-File mit früheren Leseergebnissen.

In einem Schritt T2 werden die gelesenen Botschaften nach auftretenden Codetypen ausgewertet, beispielsweise durch eine Statistik der auftretenden Codelängen. Daran kann festgestellt werden, für welche Codefamilien ein Schema erzeugt werden sollte. Wenn beispielsweise später nur sortierrelevante Codes anhand eines Schemas geprüft beziehungsweise korrigiert werden sollen, dann wird die entsprechende Codefamilie an ihrer Codelänge, an bestimmten Identifiern oder Inhalten erkannt. Ein Schema wird jeweils nur aus der Teilmenge der gelesenen Botschaften aufgebaut, die zu der entsprechenden Codefamilie gehören. Es ist denkbar, dass lediglich ein einziges Schema eingelernt wird, dies dann entweder für die häufigsten vorkommenden Codes oder eine vorgegebene Codefamilie. Vorzugsweise werden dann im Schritt T1 nur vorsortierte gelesene Botschaften bereitgestellt, die zu dieser Codefamilie passen.

In einem Schritt T3 wird aus den gelesenen Botschaften zu einer Codefamilie beziehungsweise einem Schema ausgewertet, welche Zeichen an welchen Positionen auftreten. Es kann dafür beispielsweise einfach an jede Position eine ungeordnete Menge der für diese Positionen eingelesenen Zeichen angehängt werden, oder es wird jeweils ein Bereich gebildet, in dem alle an der Position gelesenen Zeichen liegen, oder es wird je Position eine echte Häufigkeitsverteilung der gelesenen Zeichen gebildet.

In einem Schritt T4 wird dann aus der zeichenweisen Verteilung das Schema abgeleitet. Es weist in der Regel einen Fixanteil und einen variablen Anteil auf. Die fixen Zeichen des Fixanteils des Schemas wiederholen sich in allen während des Einlernens gelesenen Zeichen der jeweiligen Codefamilie, oder zur Berücksichtigung von Ausreißern wenigstens in einer Mehrzahl von m aus n Fällen. Der Fixanteil ist auch eine Möglichkeit, die Codefamilie des Schemas zu identifizieren. Es ist möglich, deshalb mindestens ein zusätzliches Schema zu erzeugen. Denn wenn sich in den gelesenen Botschaften zwei unterschiedliche Fixanteile an gleichen Positionen finden, handelt es sich vermutlich in Wahrheit nicht um dieselbe, sondern um zwei Codefamilien. Der Fixanteil kann später im Betrieb dazu dienen, das richtige Schema für den aktuell gelesenen Code zu finden.

Die variablen Zeichen des variablen Anteils des Schemas sind über die gelesenen Botschaften hinweg nicht identisch wie die fixen Zeichen, sondern bleiben innerhalb eines Teilbereichs der möglichen Zeichen. Beispielsweise sind es Buchstaben oder Ziffern. Wenn die Spannbreite der in Schritt T3 bestimmten Verteilung an einer Position zu groß wird, verliert das variable Zeichen irgendwann seinen Sinn, weil es kaum noch Vorhersagekraft hat. Es wird dann ein freies Zeichen, was in einem Schema geduldet werden kann, aber auch eine Fehlermeldung nach sich ziehen kann, dass für diese Eingangsdaten gelesener Botschaften kein geeignetes Schema möglich ist, besonders wenn es mehrere Freizeichen gibt.

Die Schritte bis T1 bis T4 müssen keineswegs nur streng einmal durchlaufen werden wie dargestellt. Insbesondere ist ein schrittweises oder iteratives Vorgehen möglich, bei dem nach und nach weitere gelesene Botschaften ausgewertet werden. Entsprechend wird dann womöglich in Schritt T2 ein weiteres Schema eröffnet und in den Schritten T3 und T4 das zu der gelesenen Botschaft passende Schema ergänzt. Eine solche iterative Anpassung der Schemata ist auch on-the-fly während des eigentlichen Lesebetriebs vorstellbar. Es kann verlangt werden, dass eine Mindestanzahl gelesener Botschaften in ein Schema eingeht, damit dessen Aussagekraft statistisch abgesichert ist.

Figur 4 zeigt eine Darstellung mehrerer gelesener Botschaften mit Illustration eines daraus eingelernten Schemas. Das ist eine spezielle vorteilhafte Implementierung des Einlernens gemäß Figur 3, mit der die Gewinnung des Vorwissens in Form von Schemata weiter illustriert wird.

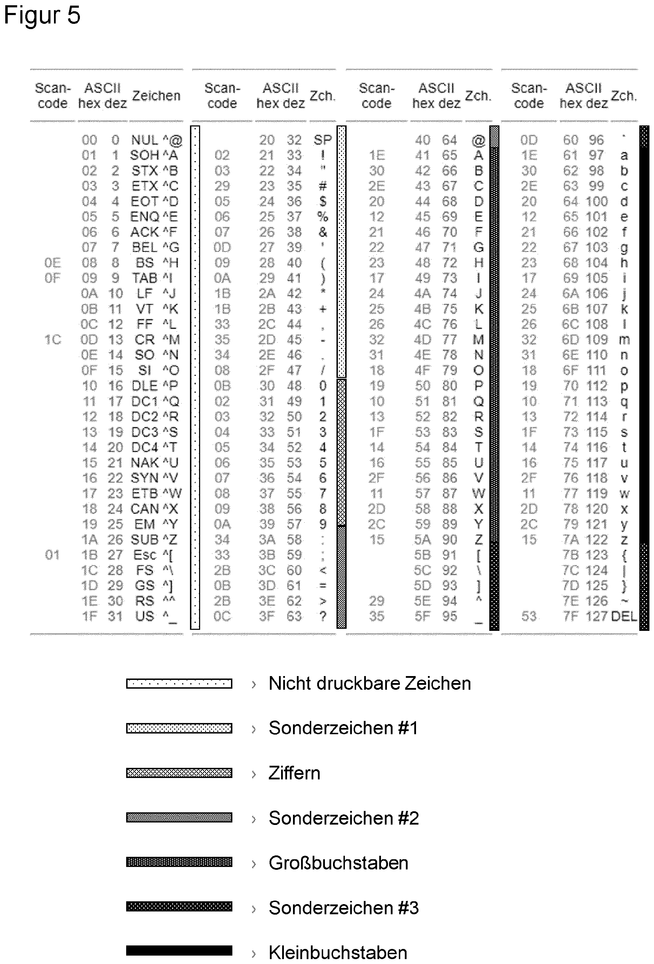

Hierzu zeigt Figur 5 ergänzend eine beispielhafte Aufteilung der möglichen Zeichen in Teilbereiche für die variablen Zeichen eines Schemas. Die Tabelle enthält die für Barcodes besonders interessanten ASCII-Werte von 0...127 und teilt diese in sieben Klassen auf: nicht druckbare Zeichen, Sonderzeichen #1, Ziffern, Sonderzeichen #2, Großbuchstaben, Sonderzeichen #3, Kleinbuchstaben. Die entsprechenden ASCII-Wertebereiche können der Tabelle direkt anhand der Legende und der markierten Balken entnommen werden. Selbstverständlich ist die Erfindung nicht auf speziell diese Klassen beschränkt. Es ist aber sinnvoll, semantische Klassen zu bilden, weil dies für den Benutzer besser verständlich ist und weil reale Codefamilien typischerweise einer Syntax folgen, bei der die variablen Zeichen auf semantische und nicht willkürliche Teilbereiche eingeschränkt sind.

Zurück zu Figur 4, sind dort links oben als Eingangsdaten gemäß Schritt T1 der Figur 3 zehn gelesene Botschaften der Codelänge 21 dargestellt. Die gelesenen Botschaften sind vorzugsweise unkorrigiert. In diesem vereinfachten Beispiel ist festgelegt, dass alle gelesenen Botschaften zur selben Codefamilie gehören und nur ein Schema eingelernt werden soll, so dass Schritt T2 der Figur 3 entfällt.

Rechts oben in Figur 4 sind entsprechend Schritt T3 der Figur 3 für jede Position des Codes die unteren und oberen ASCII-Grenzen der bisher vorgekommenen gelesenen Zeichen dargestellt. Sie werden mit einem für ein Zeichen unmöglichen Wert wie [-1, -1] initialisiert. Ein für eine jeweilige Position gemessenes Zeichen modifiziert dann die Grenzen. Beispielsweise wird in der ersten Zeile als erstes Zeichen ein "J" mit ASCII-Code 74 gelesen, und auf diesen Wert 74 wird die untere Grenze gesetzt. Beim erneuten Lesen des wiederkehrenden "J" an erste Position in der zweiten Zeile wird auch die obere Grenze auf den Wert 74 gesetzt. Alternativ könnte beim ersten Lesen eines Zeichens an einer Position die obere Grenze oder könnten beide Grenzen mit dem Wert belegt werden. Das dargestellte Vorgehen hat den Vorteil, dass zumindest die erste Bestätigung eines wiederkehrenden Werts erkennbar bleibt, hier könnte ein weiterer Parameter ergänzt oder in die Grenzen codiert werden, der die Wiederholungen zählt.

Die hinteren variablen Zeichen werden beim ersten Lesen eines Zeichens an deren Position genauso behandelt. Weitere an einer solchen Position gelesene Zeichen liegen entweder schon innerhalb der bekannten Grenzen oder überschreiben die untere Grenze beziehungsweise die obere Grenze, damit das neu gelesene Zeichen nun im jeweiligen Teilbereich umfasst ist. So ergibt sich beispielsweise für das letzte Zeichen anfangs die untere Grenze 48 des ASCII-Codes der gelesenen "0". In der zweiten Zeile wird die obere Grenze entsprechend der gelesenen "6" auf den zugehörigen ASCII-Code 54 gesetzt. Nach zehn gelesenen Botschaften ist der Teilbereich [48, 57] mit den Grenzen der ASCII-Codes für die Ziffern "0" und "9" entstanden, weil dies die beiden extremen Werte sind, die an dieser Position in den zehn Botschaften vorkommen.

Im unteren Teil der Figur 4 ist das nach dem Schritt T4 der Figur 3 entstandene Schema dargestellt. Dazu werden die im Schritt T3 je Position der Botschaft beziehungsweise des Schemas gewonnenen Verteilungen ausgewertet, die in der letzten Zeile des rechten oberen Teils der Figur 4 gezeigt sind. Im vorderen Teil der gelesenen Botschaften wiederholt sich stets die Zeichenfolge "JJD01460000", das ist der Fixanteil des Schemas. Erkannt wird dies daran, dass die unteren und oberen Grenzen an diesen Positionen übereinstimmen, es wurde also in allen zehn Botschaften das jeweils selbe Zeichen gelesen.

Der verbleibende hintere Teil der Botschaften ist der variable Anteil. Hier weichen jeweils die unteren und oberen Grenzen voneinander ab. Grundsätzlich kann nun für das jeweilige variable Zeichen direkt die dazu gewonnene Spanne gemäß den unteren und oberen Grenzen verwendet werden. Vorzugsweise wird aber auf eine Klasse verallgemeinert und die untere beziehungsweise obere Grenze auf die zugehörige Klassengrenze gesetzt. Beispielsweise kommen in den zehn Botschaften der Figur 4 an zwölfter Position, der ersten Position des variablen Anteils, nur die Ziffern "8" und "9" vor, dementsprechend wurde der Teilbereich [56, 57] bestimmt. Abweichend von diesem ursprünglichen Teilbereich wird aber nun die Klasse geöffnet, alle Ziffern sollen in dem Schema an dieser Position zulässig sein. Der Teilbereich des Schemas wird deshalb zu [48, 57].

Es ist denkbar, dass die an einer Position gelesenen Zeichen die Grenzen einer Klasse sprengen. Das kann ein Abbruchgrund für das Training sein, weil ein solches Schema nicht zulässig sein soll. Alternativ werden Multiklassen zugelassen. Dazu kann dann die zunächst ermittelte Grenze auf die nächstliegende untere beziehungsweise obere Klassengrenze verschoben werden. Dadurch entsteht ein zusammenhängender Teilbereich über mehrere Klassen. Prinzipiell sind auch disjunkte Klassen vorstellbar, etwa Ziffern und Kleinbuchstaben, die in der ASCII-Tabelle der Figur 5 voneinander getrennt sind. Es muss dann schon während der Bestimmung der Teilbereiche geprüft werden, ob ein neu gelesenes Zeichen die bisherige Klassengrenze sprengt, und dann werden zwei zusätzliche Grenzen ergänzt, um die neue Klasse zu erfassen. Eine der Klassen eines solchen variablen Zeichens mit Multiklassen kann durch ein einziges Zeichen ersetzt werden. Beispielsweise sind dann für dieses Variable Zeichen Ziffern und das Sonderzeichen "+" zulässig. Es ist sinnvoll, die Klassen gerade nur so groß werden zu lassen wie notwendig. Die variablen Zeichen sollten die im Betrieb vorkommenden Zeichen abdecken, aber unter dieser Bedingung möglichst trennscharf sein.

Das Schema in Figur 4 enthält einen Fixanteil am Anfang und einen variablen Anteil am Ende. Die Erfindung ist darauf nicht beschränkt, es kann mehrere Fixanteile und/oder mehrere variable Anteile in beliebigen Anordnungen geben. Im Prinzip kann für jede Position und jedes Zeichen individuell festgelegt werden, ob es ein fixes oder variables Zeichen ist, in dieser Hinsicht gibt es keine Beschränkungen.

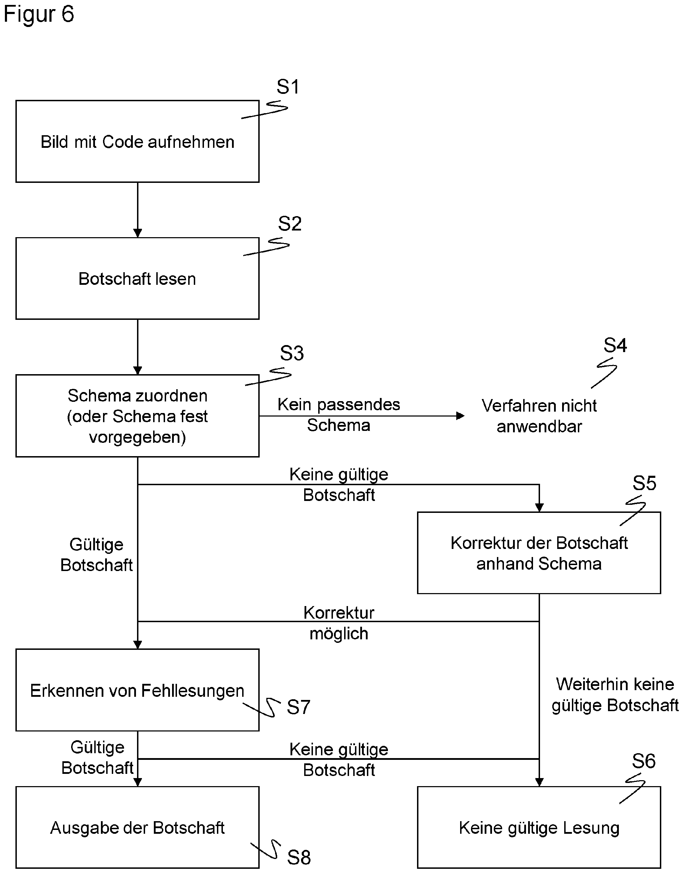

Figur 6 zeigt ein beispielhaftes Ablaufdiagramm für die Überprüfung und/oder Korrektur von aus optischen Codes gelesenen Botschaften anhand eines Schemas. Zuvor wird mindestens ein Schema vorgegeben oder nach einem zu den Figuren 3 bis 5 erläuterten Verfahren eingelernt.

In einem Schritt S1 wird von dem Codeleser 10 ein Bild mit einem Codebereich 20 aufgenommen. In einem Schritt S2 werden die Bilddaten wie zu Figur 1 beschrieben mit einem Decoder ausgewertet, um die in dem Code enthaltene Botschaft zu lesen.

In einem Schritt S3 wird ein passendes Schema zugeordnet. Dies wird anhand der Codelänge, des Codetyps und/oder anhand von Teilen der Botschaft entschieden. Insbesondere kann der Fixanteil des Schemas als eine Art Fingerabdruck verwendet werden, um zu dem Schema passende Codes zu identifizieren. Alternativ gibt es nur ein Schema beziehungsweise ist ein Schema fest vorgegeben. Sollte kein Schema zu der Botschaft passen, ist das weitere in Figur 6 dargestellte Verfahren nicht anwendbar und wird in einem Schritt S4 abgebrochen oder übersprungen. Die gelesene Botschaft wird dann so behandelt wie ohne die Erfindung, d.h. eine gelesene Botschaft kann ausgegeben werden, ein erkannter Fehler bleibt bestehen, oder es werden noch andere Korrekturen oder Überprüfungen vorgenommen als die erfindungsgemäßen anhand eines Schemas.

Mit dem passenden Schema wird nun unterschieden, ob die im Schritt S2 gelesene Botschaft eine gültige Botschaft ist oder nicht. Dazu kann beispielsweise eine Prüfsumme herangezogen werden. Womöglich sind zumindest Teile der Botschaft gar nicht lesbar gewesen.

Ist die Botschaft ungültig, so wird in einem Schritt S5 eine Korrektur anhand des Schemas versucht. Dazu wird der Fixanteil des Schemas mit den Zeichen an den entsprechenden Positionen der gelesenen Botschaft verglichen. Es sollte vorzugsweise ein Mindestanteil, beispielsweise mindestens die Hälfte, der fixen Zeichen in Schema und gelesener Botschaft übereinstimmen, um hinreichende Sicherheit zu schaffen, dass tatsächlich ein zu dem Schema passender Code mit diesem Fixanteil gelesen wurde. Möglicherweise hat ein solcher Test schon im Schritt S3 stattgefunden, dann muss das nicht wiederholt werden.

Fällt der Vergleich positiv aus, so wird der Fixanteil des Schemas in die Botschaft übertragen. Dabei werden die fixen Zeichen der Botschaft mit denjenigen des Schemas überschrieben, und erforderlichenfalls werden Zeichen eingeschoben, um insgesamt auf die richtige Codelänge zu kommen. In einer anderen Ausführungsform kann verlangt sein, dass die Codelänge der Botschaft schon vor der Korrektur der geforderten Codelänge des Schemas entspricht, dann werden keine Zeichen eingeschoben.

Der Fixanteil der Botschaft ist nach der Korrektur gemäß Schritt S5 erzwungenermaßen korrekt. Es besteht noch eine Restwahrscheinlichkeit, dass der Mindestanteil der Übereinstimmung im Fixanteil nicht ausreicht und der gelesene Code diesen Fixanteil tatsächlich doch nicht aufweist. Möglicherweise lag aber der Fehler nicht allein im Fixanteil, sondern es sind zusätzlich ein Zeichen oder mehrere Zeichen in dem variablen Anteil falsch decodiert worden. Um derartige Fälle auszuschließen, wird die korrigierte Botschaft nochmals einer Überprüfung beispielsweise anhand einer Prüfsumme unterzogen. Im Erfolgsfall wird nun angenommen, dass die korrigierte Botschaft ein richtiges Leseergebnis ist. Andernfalls kann noch eine Korrektur im variablen Anteil aus der Prüfsumme versucht werden, wie einleitend beschrieben, aber die Mächtigkeit und Verlässlichkeit dieses Vorgehens ist begrenzt.

In einem ersten Korrekturbeispiel sei das Schema dasjenige, das in Figur 4 eingelernt wurde, mit einer Codelänge 21 und dem Fixanteil "JJD01460000" in den Positionen 1-11 gefolgt von einem variablen Anteil von Ziffern in den Positionen 12-21. Dieses Schema wird auch in allen weiteren Korrekturbeispielen herangezogen. Gelesen wurde nun beispielhaft die Botschaft "**X**JD0**23**600009278066464" mit Prüfsumme 18 und fett gedruckten Abweichungen von dem Fixanteil des Schemas. Die Überprüfung anhand der Prüfsumme ist nicht erfolgreich, es wird also versucht zu korrigieren und der Fixanteil, der zu deutlich über der Hälfte übereinstimmt, in die gelesene Botschaft übertragen: "JJD014600009278066464". Jetzt stimmt auch die Prüfsumme, es ist also eine gültige Botschaft.

In einem zweiten Korrekturbeispiel sei die gelesene Botschaft "D014600009278066464". Der Fehler liegt nun darin, dass die ersten zwei Zeichen nicht gelesen wurden, es fehlt das anfängliche "JJ". Die Botschaft ist dadurch um zwei Zeichen gegenüber der geforderten Codelänge von 21 zu kurz. Es ist daher unerheblich, ob die Prüfsumme zufällig fehlerhaft eine gültige Botschaft anzeigt, dies wäre ein unabhängiger zweiter Indikator. Die Übereinstimmung im Fixanteil ist immer noch größer als der geforderte Mindestanteil von 50%. Daher kann der Fixanteil des Schemas positionsrichtig eingefügt werden, d.h. die beiden ersten Zeichen "JJ" des Fixanteils werden der gelesenen Botschaft zur Korrektur vorangestellt. Das bringt die gelesene Botschaft auf die richtige Codelänge 21, und auch die errechnete Prüfsumme ist nun korrekt.

In einem dritten Korrekturbeispiel ist eine Botschaft vor der Korrektur deshalb nicht gültig, weil die Prüfsumme nicht gelesen werden konnte. Das ändert zunächst nichts an den Korrekturmöglichkeiten. Allerdings ist das Ergebnis wesentlich unzuverlässiger, weil eine abschließende Überprüfung nicht möglich ist, lediglich die Codelänge kann noch geprüft werden. Hier bietet es sich an, eine wiederholte Codelesung zu fordern. In einigen Ausführungsformen wird ohnehin jeder Code mehrfach gelesen, dann besteht die Möglichkeit, den entsprechenden Schwellenwert für mehrfache erfolgreiche Decodierungen zu erhöhen, um hinreichend sicher sein zu können, dass die Zeichen in den Positionen des variablen Anteils ohne Fehler ausgelesen werden konnten.

Auf die Korrektur des Schrittes S5 folgt wiederum eine Fallunterscheidung. Wenn auch mit der Korrektur keine gültige Botschaft rekonstruiert werden konnte, bleibt es in einem Schritt S6 bei einem Lesefehler (in diesem Fall NoRead). War andernfalls die Korrektur erfolgreich, so setzt sich das Verfahren in einem Schritt S7 mit einer Erkennung von Fehllesungen fort. In diesen Schritt S7 mündet auch der zweite Pfad der auf Schritt S3 folgenden Fallunterscheidung, wenn nämlich die Botschaft schon ohne Korrektur gemäß Schritt S5 gültig war. Es wäre im Übrigen abweichend von Figur 6 auch denkbar, die Korrektur gemäß Schritt S5 immer durchzuführen, auch für schon nach Schritt S3 gültige Botschaften, je nachdem, ob dem ursprünglichen Lesen der Botschaft oder den Schemata mehr vertraut werden soll.

In dem Schritt S7 werden nun noch Fehllesungen (MisRead) erkannt. Das sind diejenigen Fälle, in denen mit oder ohne Korrektur gemäß Schritt S5 eine gültige Botschaft gelesen wurde, bei der insbesondere die aus den Nutzzeichen errechnete Prüfsumme und die gelesene Prüfsumme übereinstimmen. Diese Validierung ist nämlich, wie einleitend schon diskutiert, nur im Einfehlerfall zuverlässig, Mehrfachfehler können zufällig eine richtige Prüfsumme ergeben.

Zunächst kann optional, falls dies nicht in Schritt S3 beziehungsweise S5 schon geschehen ist, anhand eines Vergleichs des Fixanteils des Schemas mit den entsprechenden Zeichen der Botschaft an den Positionen des Fixanteils sichergestellt werden, dass das Schema zu der Botschaft passt. Dazu muss der Fixanteil zu einem Mindestanteil von beispielsweise 50% übereinstimmen.

Für den variablen Anteil des Schemas wird geprüft, ob die variablen Zeichen der gelesenen Botschaft an den zugehörigen Positionen in den Teilbereichen des Schemas liegen. Wenn beispielsweise das Schema an einer Position eine Ziffer verlangt, aber ein Sonderzeichen gelesen wurde, wird die Botschaft nicht als gültig angesehen. Außerdem kann geprüft werden, ob die Codelänge des Schemas gleich derjenigen der gelesenen Botschaft ist. Eine nach den Kriterien des Schrittes S7 doch nicht gültige Botschaft beendet den Ablauf gemäß Figur 6 im Schritt S6 ohne gültige Lesung (in diesem Fall MisRead).

Andernfalls wird die Botschaft als gültig angesehen. Der Decoder hat sie ursprünglich ohne Fehler lesen können, oder es war möglich, sie im Schritt S5 zu korrigieren, und im Schritt S7 wurde auch keine Fehllesung erkannt. Die Botschaft wird in einem Schritt S8 ausgegeben beziehungsweise mit bereits vor der Erfindung üblichen Schritten weiterverarbeitet.

In einigen nun folgenden Beispielen für die Erkennung von Fehllesungen wird weiterhin das Schema verwendet, das in Figur 4 eingelernt wurde. In einem ersten sehr einfachen Beispiel wurde die Botschaft "JJD014600005183211" gelesen. Sie ist mit 18 Zeichen gegenüber der Codelänge 21 des Schemas zu kurz und daher eine Fehllesung.

In einem zweiten Beispiel wurde die Botschaft "JJD01460000**MJ**18321108" gelesen. Nun stimmt die Codelänge, aber an den fett gedruckten Stellen wurden mit "MJ" Großbuchstaben statt den Ziffern des Schemas gelesen. Es handelt sich ebenfalls um eine Fehllesung.

In einem dritten Beispiel liegt eine Fehllesung vor, die auch durch das Vorgehen gemäß Schritt S7 nicht aufgedeckt werden kann. Im Gegensatz zu den fixen Zeichen lassen die variablen Zeichen einen gewissen Spielraum, bei sich immer noch Mehrfachfehler zu der gelesenen Prüfsumme kompensieren. Dabei kann die Prüfsumme richtig gelesen oder selbst falsch gelesen und damit Teil der Mehrfachfehler sein. Die richtige Botschaft lautet nun "JJD0146000092**83**279219", gelesen wurde "JJD0146000092**75**279219" mit fett markierten Ziffern, an denen mit einer falsch ausgelesenen Prüfsumme korrigiert wurde. Dieser Fehler ist nicht erkennbar. Einerseits stimmt die Prüfsumme, deren Funktion wurde durch den vorgenommenen Korrekturversuch gleichsam verbraucht. Es wurden zudem Ziffern eingesetzt, das Schema ist damit erfüllt. Hätte die Korrektur über die Prüfsumme keine Ziffern eingefügt, wäre das über das Schema noch aufgefallen. In diesem dritten Beispiel würde die gelesene Botschaft im Schritt S8 als gültig angesehen, obwohl es eigentlich eine Fehllesung (MisRead) ist. Natürlich hätte auf den Korrekturversuch über die Prüfsumme verzichtet werden können, dann wäre es bei einer Nichtlesung (NoRead) geblieben. Dieses Risiko besteht bei einer Korrektur über die Prüfsumme immer, wie schon einleitend diskutiert, damit erhöht sich die Leserate (weniger NoRead), aber zugleich auch die Gefahr einer Fehllesung (MisRead). Durch die erfindungsgemäßen Schemata kann letztere Gefahr zumindest weiter verringert werden.

Es ist sinnvoll, die Schemata auf eine übersichtliche, nachvollziehbare Weise darzustellen oder zu repräsentieren. Das erleichtert die Diagnose und ein eventuelles manuelles Optimieren, aber auch die fehlerfreie und systematische Programmierung der auf die Schemata bezogenen Schritte. In einer einfachen Implementierung können an die Positionen eines Schemas Grenzen der Teilbereiche angehängt werden wie im Beispiel der Figur 4. Dies kann zu Listen mit den Grenzen mehrerer Klassen und/oder zulässiger Zeichen der Teilbereiche erweitert werden.

In Pseudocode lässt sich das wie folgt ausdrücken. Dabei ist die Liste der Klassen ("Type") erweiterbar, insbesondere mit denjenigen der Figur 5.
Schema = Array of CodeCharSchema;
CodeCharSchema = List of SingleSchemaEntry;
SingleSchemaEntry =
Record
   Type : (SingleCharacter, Charlnterval);
   Value : Char; /* Einzelbuchstabe, z.B. ein Sonderzeichen */
   Min, Max : Char; /* Dadurch wird ein Intervall beschrieben */
End;

Eine weitere Alternative zur Beschreibung von Schemata sind reguläre Ausdrücke. Damit wird die Definition von Schemata auf eine streng definierte Struktur zurückgeführt, die vielen Benutzern bekannt ist und für die es Standardbausteine zum Entwerfen, Editieren und Konvertieren gibt. Ein Beispiel für ein als regulärer Ausdruck definiertes Schema ist "JJD...[a-z][a-z][0-9]...". Es beginnt mit einem Fixanteil "JJD", gefolgt von drei beliebigen Zeichen, anschießend zwei Kleinbuchstaben, einer Ziffer und dann nochmals drei beliebigen Zeichen. Bemerkt sei noch, das keineswegs jeder reguläre Ausdruck ein Schema sein kann, beispielsweise würde "^...[0-9]...$" einen Absatzanfang und ein Absatzende enthalten, was in den Schemata keine Entsprechung haben kann. Die Editierfunktionen sollten diese Möglichkeiten gar nicht erst anbieten oder zumindest durch Warnungen abfangen.

Es ist vorstellbar, eine proprietäre Systematik oder Sprache für Schemata zu entwerfen, die reguläre Ausdrücke ersetzt. Das lässt sich dann besser an die Erfordernisse der Schemata anpassen. Beispielsweise können Großbuchstaben mit "C", Kleinbuchstaben mit "c" und Ziffern mit "N" bezeichnet werden, während fixe Zeichen in Klammern erscheinen und freie Zeichen weiterhin durch einen "." repräsentiert sind. Das ergäbe dann für das obige Beispiel eines regulären Ausdrucks die kompaktere Schreibweise "[JJD]...ccN...".

## Patentansprüche

1. Computerimplementiertes Verfahren zum Lesen eines optischen Codes (20),
der eine Botschaft codiert, die eine Zeichenkette mit einer Vielzahl von Zeichen aufweist, mit den Schritten
Aufnehmen von Bilddaten mit dem optischen Code (20),
Auswerten der Bilddaten mit Lesen der Botschaft,
Vergleichen der gelesenen Zeichen der Botschaft mit einem Schema, das einen Fixanteil enthält, d.h. für mindestens eine Position der Botschaft ein fixes Zeichen, das in zu lesenden optischen Codes (20) an dieser Position erwartet wird, so dass bekannt ist, wie die Botschaft an dieser Position lauten müsste, und Erkennen einer falsch gelesenen Botschaft, wenn der Fixanteil des Schemas nicht wie erwartet in der Botschaft gelesen wurde, und/oder Korrektur der gelesenen Botschaft, indem aus dem Vorwissen des Fixanteils des Schemas Teile der Botschaft korrigiert oder ersetzt werden,
**dadurch gekennzeichnet,**
**dass** das Schema für mindestens eine Position der Botschaft ein variables Zeichen enthält, das in zu lesenden Codes (20) an dieser Position erwartet wird,
wobei ein variables Zeichen auf einen Teilbereich der möglichen Zeichen, nicht aber ein fixes Zeichen festgelegt ist, somit nur in einem Teilbereich der insgesamt möglichen Zeichen variiert, und dass geprüft wird, ob die variablen Zeichen der gelesenen Botschaft an den zugehörigen Positionen in den Teilbereichen des Schemas liegen.

2. Verfahren nach Anspruch 1,
wobei das Schema eine Codelänge aufweist und/oder für jede Position ein fixes Zeichen oder ein variables Zeichen enthält.

3. Verfahren nach Anspruch 1 oder 2,
wobei als das anzuwendende Schema unter mehreren Schemata dasjenige ausgewählt wird, dessen fixe Zeichen sich am besten in der gelesenen Botschaft wiederfinden.

4. Verfahren nach einem der vorhergehenden Ansprüche,
wobei der Code (20) eine Prüfsumme aufweist und das Lesen der Botschaft anhand der Prüfsumme validiert wird.

5. Verfahren nach Anspruch 4,
wobei an einer Position eines variablen Zeichens ein nicht in den Teilbereich der für das variable Zeichen möglichen Zeichen fallendes oder ein nicht lesbares Zeichen mittels der Prüfsumme korrigiert wird und das Ergebnis nur als korrekt gelesene Botschaft akzeptiert wird, wenn das korrigierte Zeichen in den Teilbereich der für das variable Zeichen möglichen Zeichen fällt.

6. Verfahren nach einem der vorhergehenden Ansprüche,
wobei dann, wenn ein Mindestanteil der fixen Zeichen des Schemas, insbesondere mindestens die Hälfte, in der Botschaft korrekt gelesen wurde, die übrigen fixen Zeichen des Schemas in die Botschaft übernommen werden.

7. Verfahren nach einem der vorhergehenden Ansprüche,
wobei eine Botschaft, deren Länge nicht mit der Codelänge des Schemas übereinstimmt oder die an einer Position eines variablen Zeichens ein Zeichen aufweist, das nicht in den Teilbereich der für das variable Zeichen möglichen Zeichen fällt, als Fehllesung eingestuft wird.

8. Verfahren nach einem der vorhergehenden Ansprüche,
wobei ein Schema mindestens einen der folgenden Teilbereiche der möglichen Zeichen eines variablen Zeichens aufweist: nicht druckbare Zeichen, Sonderzeichen, Ziffern, Buchstaben, Kleinbuchstaben, Großbuchstaben, insbesondere durch ASCII-Codes.

9. Verfahren nach einem der vorhergehenden Ansprüche,
wobei ein Schema als regulärer Ausdruck formuliert wird, der für die jeweiligen Positionen die zulässigen Zeichen angibt.

10. Verfahren nach einem der vorhergehenden Ansprüche,
wobei zum Einlernen eines Schemas eine Vielzahl gelesener Botschaften ausgewertet wird, wobei insbesondere die gelesenen Botschaften im Betrieb erfasst oder aus einem Logfile geladen werden.

11. Verfahren nach Anspruch 10,
wobei ein Schema aus einer Verteilung gelesener Zeichen an den jeweiligen Positionen der gelesenen Botschaft eingelernt wird.

12. Verfahren nach Anspruch 10 oder 11,
wobei an Positionen, an denen immer das gleiche Zeichen gelesen wird, das entsprechende fixe Zeichen eingelernt wird und an Positionen, an denen verschiedene Zeichen gelesen werden, der davon gebildete Teilbereich als variables Zeichen eingelernt wird.

13. Verfahren nach einem der Ansprüche 10 bis 12,
wobei ein Schema zunächst mit leeren Bereichen je Position initialisiert wird, das jeweilige erste an einer Position gelesene Zeichen für diese Position gespeichert wird und jedes an einer Position nach dem ersten Zeichen für diese Position gelesene Zeichen, das für diese Position noch unbekannt war, den Teilbereich für diese Position so erweitert, dass das gelesene Zeichen umfasst ist.

14. Optoelektronischer Codeleser (10) mit mindestens einem Lichtempfangselement (24) zur Erzeugung von Bilddaten aus Empfangslicht und mit einer Steuer- und Auswertungseinheit (26), in der ein Verfahren zum Lesen von optischen Codes (20) nach einem der vorhergehenden Ansprüche implementiert ist.

## Claims

1. A computer-implemented method for reading an optical code (20) encoding a message comprising a character string having a plurality of characters, comprising the steps of
capturing image data with the optical code (20);
evaluating the image data and reading the message;
comparing the read characters of the message with a scheme which contains a fixed portion, i.e. for at least one position of the message, a fixed character which is expected at this position in optical codes (20) to be read, so that it is known what the message should read like at this position;
and recognizing an incorrectly read message if the fixed portion of the scheme was not read in the message as expected, and/or correcting the read message by correcting or replacing parts of the message from the prior knowledge of the fixed portion of the scheme,
**characterized in that** the scheme contains, for at least one position of the message, a variable character which is expected at this position in codes (20) to be read, a variable character that is fixed to a partial range of the possible characters, but is not a fixed character, thus varies only in a partial range of the total possible characters, and **in that** a check is made as to whether the variable characters of the read message are located at the associated positions in the partial ranges of the scheme.

2. The method according to claim 1,
wherein the scheme has a code length and/or contains a fixed character or a variable character for each position.

3. The method according to claim 1 or 2,
wherein the scheme to be applied is selected from a plurality of schemes as the scheme whose fixed characters are best reflected in the read message.

4. The method according to any of the preceding claims,
wherein the code (20) comprises a checksum and the reading of the message is validated using the checksum.

5. The method according to claim 4,
wherein, at a position of a variable character, a character which does not fall within the partial range of characters possible for the variable character or a character which cannot be read is corrected by means of the checksum and the result is only accepted as a correctly read message if the corrected character falls within the partial range of characters possible for the variable character.

6. The method according to any of the preceding claims,
wherein, if a minimum proportion of the fixed characters of the scheme, in particular at least half, has been read correctly in the message, the remaining fixed characters of the scheme are adopted in the message.

7. The method according to any of the preceding claims,
wherein a message whose length does not correspond to the code length of the scheme or which has a character at a position of a variable character which does not fall within the partial range of possible characters for the variable character is classified as a misread.

8. The method according to any of the preceding claims,
wherein a scheme comprises at least one of the following partial ranges of the possible characters of a variable character: non-printable characters, special characters, digits, letters, lowercase letters, uppercase letters, in particular by ASCII codes.

9. The method according to any of the preceding claims,
wherein a scheme is formulated as a regular expression which specifies the permissible characters for the respective positions.

10. The method according to any of the preceding claims,
wherein a plurality of read messages is evaluated for teaching a scheme, wherein in particular the read messages are recorded during operation or loaded from a log file.

11. The method according to claim 10,
wherein a scheme is taught from a distribution of read characters at the respective positions of the read message.

12. The method according to claim 10 or 11,
wherein at positions at which the same character is always read, the corresponding fixed character is taught in and at positions at which different characters are read, the partial range formed therefrom is taught in as a variable character.

13. The method according to any of claims 10 to 12,
wherein a scheme is first initialized with empty ranges per position, the respective first character read at a position is stored for this position, and each character read at a position after the first character for this position, which was still unknown for this position, extends the partial range for this position such that the read character is included.

14. An optoelectronic code reader (10) having at least one light-receiving element (24) for generating image data from received light and having a control and evaluation unit (26) in which a method for reading optical codes (20) according to any of the preceding claims is implemented.

## Revendications

1. Procédé mis en oeuvre par ordinateur pour lire un code optique (20) codant un message comprenant une chaîne de caractères comportant une pluralité de caractères, comprenant les étapes suivantes
enregistrement des données d'image avec le code optique (20),
évaluer les données d'image et lire le message,
comparer les caractères lus du message avec un schéma contenant une partie fixe, c'est-à-dire, pour au moins une position du message un caractère fixe qui est attendu à cette position dans les codes optiques (20) à lire, de sorte que l'on sait comment le message devrait être à cette position,
et reconnaître un message mal lu si la partie fixe du schéma n'a pas été lue dans le message comme prévu, et/ou corriger le message lu en corrigeant ou en remplaçant des parties du message à partir de la connaissance préalable de la partie fixe du schéma,
**caractérisé en ce que** le schéma contient, pour au moins une position du message, un caractère variable qui est attendu à cette position dans les codes (20) à lire, de sorte que l'on sait comment le message devrait se lire à cette position un caractère variable qui est attendu à cette position dans les codes (20) à lire, dans lequel un caractère variable est fixé à une plage partielle des caractères possibles, mais pas un caractère fixe, et qui ne varie donc que dans une plage partielle de l'ensemble des caractères possibles, et **en ce qu'**il est vérifié si les caractères variables du message lu sont situés aux positions correspondantes dans les plages partielles du schéma.

2. Procédé selon la revendication 1,
dans lequel le schéma comprend une longueur de code et/ou contient un caractère fixe ou un caractère variable pour chaque position.

3. Procédé selon la revendication 1 ou 2,
dans lequel le schéma à appliquer est sélectionné parmi plusieurs schémas comme étant celui dont les caractères fixes sont le mieux reflétés dans le message lu.

4. Procédé selon l'une des revendications précédentes,
dans lequel le code (20) comprend une somme de contrôle et la lecture du message est validée à l'aide de la somme de contrôle.

5. Procédé selon la revendication 4,
dans lequel, à une position d'un caractère variable, un caractère qui n'entre pas dans la plage partielle des caractères possibles pour le caractère variable ou un caractère qui ne peut pas être lu est corrigé au moyen de la somme de contrôle et le résultat est accepté comme message correctement lu uniquement si le caractère corrigé entre dans la plage partielle des caractères possibles pour le caractère variable.

6. Procédé selon l'une des revendications précédentes,
dans lequel, si une proportion minimale des caractères fixes du schéma, en particulier au moins la moitié, a été lue correctement dans le message, les caractères fixes restants du schéma sont adoptés dans le message.

7. Procédé selon l'une des revendications précédentes,
dans lequel un message dont la longueur ne correspond pas à la longueur du code du schéma ou qui comprend un caractère à une position d'un caractère variable qui n'entre pas dans la plage partielle des caractères possibles pour le caractère variable est classé comme une erreur de lecture.

8. Procédé selon l'une des revendications précédentes,
dans lequel un schéma comprend au moins l'une des plages partielles suivantes des caractères possibles d'un caractère variable: caractères non imprimables, caractères spéciaux, chiffres, lettres, lettres minuscules, lettres majuscules, en particulier par des codes ASCII.

9. Procédé selon l'une des revendications précédentes,
dans lequel un schéma est formulé sous la forme d'une expression régulière qui spécifie les caractères autorisés pour les positions respectives.

10. Procédé selon l'une des revendications précédentes,
dans lequel une pluralité de messages lus est évaluée pour l'enseignement d'un schéma, les messages lus étant notamment saisis pendant le fonctionnement ou chargés à partir d'un fichier journal.

11. Procédé selon la revendication 10,
dans lequel un schéma est enseigné à partir d'une distribution de caractères lus aux positions respectives du message lu.

12. Procédé selon la revendication 10 ou 11,
dans lequel, aux positions où le même caractère est toujours lu, le caractère fixe correspondant est enseigné et, aux positions où différents caractères sont lus, la plage partielle formée par ceux-ci est enseignée comme caractère variable.

13. Procédé selon l'une des revendications 10 à 12,
dans lequel un schéma est d'abord initialisé avec des plages vides par position, le premier caractère lu respectif à une position est stocké pour cette position, et chaque caractère lu à une position après le premier caractère pour cette position, qui était encore inconnu pour cette position, étend la plage partielle pour cette position de telle sorte que le caractère lu est inclus.

14. Lecteur de code optoélectronique (10) avec au moins un élément de réception de lumière (24) pour générer des données d'image à partir de la lumière de réception et avec une unité de commande et d'évaluation (26) dans laquelle est mis en aeuvre un procédé de lecture de codes optiques (20) selon l'une des revendications précédentes.
